(19) Europäisches Patentamt
European Patent Office
Office européen des brevets

(11) **EP 0 729 071 A1**

(12) **EUROPÄISCHE PATENTANMELDUNG**

(43) Veröffentlichungstag:
28.08.1996 Patentblatt 1996/35

(51) Int. Cl.⁶: **G03F 7/12**, B41C 1/14, G03F 7/095

(21) Anmeldenummer: 95102102.1

(22) Anmeldetag: 15.02.1995

(84) Benannte Vertragsstaaten:
AT BE CH DE DK ES FR GB GR IE IT LI LU MC NL PT SE

(71) Anmelder: **Schablonentechnik Kufstein Aktiengesellschaft**
**A-6330 Kufstein (AT)**

(72) Erfinder: **KURZ, Franz**
**A-6300 Wörgl (AT)**

(74) Vertreter: **TER MEER - MÜLLER - STEINMEISTER & PARTNER**
**Mauerkircherstrasse 45**
**81679 München (DE)**

(54) **Verfahren zur Herstellung einer Druckschablone**

(57) Zur Herstellung einer Druckschablone (10) insbesondere für die Textildrucktechnik werden wenigstens folgende Schritte ausgeführt: Bereitstellung eines Grundkörpers (12); Aufbringen einer wenigstens eingefärbten ersten Harzschicht (7) auf die Oberfläche des Grundkörpers (12); Aufbringen einer zweiten transparenten und photosensibilisierten Harzschicht (8) auf die erste Harzschicht (7); ortsselektives Belichten der Harzschichten (7, 8) zwecks Vernetzung der belichteten Stellen; und Entwickeln der belichteten Harzschichten (7, 8). Infolge der strahlungsabsorbierenden Eigenschaften der ersten Harzschicht (7) lassen sich mit diesem Verfahren Muster mit sehr genauen Konturen herstellen.

Fig.4

## Beschreibung

Die Erfindung bezieht sich auf ein Verfahren zur Herstellung einer Druckschablone, die sich insbesondere zum Bedrucken von Textilien eignet, gemäß dem Oberbegriff des Patentanspruchs 1.

Aus der EP-A-92 118 032 ist bereits ein Verfahren zur Herstellung einer Siebdruckschablone bekannt, bei dem zunächst ein hohlzylindrisches Rundsieb bereitgestellt wird. Auf die äußere Oberfläche des Rundsiebs wird dann eine photoempfindliche Lackschicht aufgetragen, die anschließend mittels einer Lasereinrichtung ortsselektiv belichtet wird, um eine Vernetzung bzw. Aushärtung der belichteten Stellen der Lackschicht zu erreichen, wobei während der Belichtung das Rundsieb gedreht wird. Anschließend wird die so belichtete Lackschicht entwickelt.

Es hat sich herausgestellt, daß hierbei die vom Laserstrahl eingebrachte Bestrahlungsenergie beim ersten Durchlauf des Strahls durch die zu polymerisierende Lack- bzw. Harzschicht nicht vollkommen für die Polymerisation oder die Initialisierung derselben aufgebraucht wird, sondern nur in einem Ausmaß, in welchem dies durch die vorhandenen Absorptionsquerschnitte der Harz- und/oder Sensibilisator-Moleküle ermöglicht wird. Da die Schichtdicke des aufgetragenen Photoharzes bzw. Photolacks im allgemeinen dünn ist, wird ein Großteil der eingebrachten Strahlungsenergie von dem metallischen Untergrund, also der Oberfläche des Siebs, reflektiert. Da diese zudem einen räumlichen Krümmungszustand aufweist, bedingt durch die Zylinderform, Perforation oder durch Oberflächenfehler, wird die Strahlungsenergie darüber hinaus auch gestreut. Die Polymerisation wird somit auch durch das reflektierte Licht angeregt oder initiiert und daher auch in jenen Bereichen, die ausschließlich durch das reflektierte bzw. gestreute Licht durchstrahlt wurden. Dies führt zu ungewollten Verbreiterungen gegenüber den gewünschten Konturen, die darüber hinaus wegen der Unterschiede der Intensität der von den Stegen bzw. Oberflächenfehlern abgestreuten Strahlung äußerst unregelmäßig sind.

Man versuchte dieser Erscheinung bis jetzt dadurch entgegenzuwirken, daß man die Schichtdicke so dünn hielt, daß auch die reflektierte bzw. gestreute Strahlung noch nicht nennenswert breitere Bereiche erfaßte. Es wird aber dann durch unterschiedliche Einflüsse die Polymerisation oder der nachfolgende Entwicklungsprozeß schwierig.

Diese Einflüsse sind einmal die mit abnehmender Schichtstärke geringer werdende Absorptionsrate, welche zur Erzeugung radikalischer Bruchstücke der Moleküle des Harzes oder des Photosensibilisators führt und die Polymerisation bewirkt, und zum anderen die höhere Angriffsempfindlichkeit beim nachfolgenden Entwicklungsprozeß infolge der geringeren Schichtdicke. Der Entwicklungsvorgang bei polymerisierenden Photoharzen nützt den Umstand aus, daß die vernetzten Harzbereiche eine größere Beständigkeit zum Beispiel gegenüber wäßrigen, alkalischen Medien haben als die unvernetzten. Die unvernetzten Stellen werden bei Einwirkung einer alkalischen Flüssigkeit, die zum Beispiel eine Waschsodalösung oder verdünnte Natronlauge sein kann, daher schneller aufgelöst als die vernetzten Stellen. Ist jedoch die Photolack- bzw. Harzschicht sehr dünn, dann können diese Medien sehr schnell durch die Schicht hindurchdiffundieren, die Haftung zwischen den vernetzten Stellen und dem Untergrund aufheben und so die Ablösung auch dieser Stellen vom metallischen Sieb bewirken.

Eine weitere Möglichkeit der Verhinderung der Konturenverbreiterung ist die Einfärbung der Schichten mit lichtabsorbierenden Farbstoffen. Solche Farbstoffe können prinzipiell auch die Möglichkeit einer weiterführenden Sensibilisierung bergen. Hier werden aber solche Farbstoffe verwendet, die die Strahlungsenergie vorzugsweise in andere Energieformen umwandeln (dissipieren), nicht aber als Polymerisationsinitiator wirken. Eine solche Einfärbung der Harzschicht vermindert die Gefahr der Härtung der Photoharze an ungewünschten Stellen und bewirkt eine gute Konturentreue, bringt aber als Nachteil eine Desensibilisierung der Harze mit sich.

Es konnte beobachtet werden, daß besonders in den Öffnungen des Schablonensiebs die Strahlungsenergie durch Reflexion an den Rändern der Öffnung konzentriert wird und dort zu unerwünschten Härtungen primär unbelichteter Harzbereiche führt.

Der Erfindung liegt die Aufgabe zugrunde, ein Verfahren der genannten Art anzugeben, mit dem sich sehr feine Konturen herstellen lassen, ohne daß Ablösungserscheinungen der vernetzten Stellen der Harzschicht zu befürchten sind.

Ein erfindungsgemäßes Verfahren zur Herstellung einer Druckschablone umfaßt folgende Schritte:

- Bereitstellung eines Grundkörpers;
- Aufbringen einer wenigstens eingefärbten ersten Harzschicht auf die Oberfläche des Grundkörpers;
- Aufbringen einer zweiten transparenten und photosensibilisierten Harzschicht auf die erste Harzschicht;
- ortsselektives Belichten der Harzschichten zwecks Vernetzung der belichteten Stellen; und
- Entwickeln der belichteten Harzschichten.

Gemäß der Erfindung kann mit anderen Worten eine erste Harzschicht z. B. auf ein metallisches oder metallisiertes Grundsieb aufgetragen werden, welche im wesentlichen die Öffnungen des Grundsiebs ausfüllt. Diese erste Harzschicht ist mit einem die Lichtenergie dissipativ absorbierenden Farbstoff eingefärbt und entweder gar nicht oder nur schwach sensibilisiert. Über diese erste Harzschicht wird eine dünne und vorzugsweise stark transparente zweite Harzschicht gelegt, die einen hohen Anteil eines Photosensibilisators aufweist. Die erste und die zweite Harzschicht können dabei jeweils eine Dicke von 5 bis 10 µm aufweisen. In den Öffnungen des Siebs können die Schichtdicken durch Effekte der Oberflächenspannung allerdings höher sein. Im Anschluß hieran wird das beschichtete Schablonensieb, das als zylindrisches oder flaches Sieb vorliegen kann, durch Strahlung jener Wellenlänge musterkonform belichtet, auf welche der Photosensibilisator anspricht. Diese Wellenlänge liegt z. B. im Bereich von 380 nm bis etwa 532 nm und läßt sich durch einen geeigneten Laser zur Verfügung stellen.

Das erfindungsgemäße Verfahren läßt sich aber auch auf nicht siebförmig ausgestaltete Grundkörper anwenden, die z. B. Vollzylinder oder Hohlzylinder mit geschlossener Mantelfläche sind und aus Metall bestehen oder eine metallisierte Oberfläche aufweisen können. In diesem Fall wird zunächst eine erste dünne Schicht eines stark eingefärbten Harzes zur Verhinderung der Reflexion aufgebracht, wobei dieses Harz entweder gar nicht oder nur schwach photosensibilisiert ist. Darauf kommt eine stark photosensibilisierte und transparente Harzschicht zu liegen. Die beiden Harzschichten weisen hierbei im Mittel jeweils eine Dicke von etwa 5 $\mu$m bis 10 $\mu$m auf. Nach musterkonformer Belichtung und Entwicklung dieser Harzschichten liegt eine Matrize vor, die sich anschließend zur Bildung eines Zylindersiebs heranziehen läßt, indem die jetzt vorhandenen Hohlräume in den Harzschichten durch Metall aufgefüllt werden. Zu diesem Zweck kann beispielsweise ein Aufnickelungsvorgang in einem galvanischen und manchmal auch chemischen Nickelbad durchgeführt werden. Das zylindrische Nickelsieb wird anschließend in geeigneter Weise vom Grundkörper abgenommen und läßt sich dann als Siebdruckschablone verwenden. Bei dieser Matrizengravur besteht die Möglichkeit, unterschiedliche Abstände der Sieböffnungen bei der Halbtontechnik zu realisieren. Mit anderen Worten können hier gleichgroße Sieböffnungen in unterschiedlichen Abständen angeordnet werden, wobei man diese Abstände größer wählt, wenn weniger Farbe auf das zu bedruckende Substrat gelangen soll, und umgekehrt. Eine Variation der Öffnungsabstände des Siebs hat gezeigt, daß sich dann die aus Farbüberlagerungen entstehende Mischfarbenbildung sehr viel gleichmäßiger realisieren läßt. Es entsteht in diesem Fall keine Art Farbmoire, wie dies sonst bei Verwendung von Siebdruckschablonen üblich ist, bei denen gleiche Abstände zwischen den Sieböffnungen vorliegen und die Öffnungen unterschiedlich groß sind.

Der Vorteil der erfindungsgemäßen Zweischichttechnik besteht in einer Verhinderung der unerwünschten Polymerisationserscheinungen der erst durch das reflektierte oder gestreute Licht belichteten Harzbereiche, so daß sich feinere Konturen herstellen lassen und trotzdem eine so große Schichtdicke des Harzsystems erzielt wird, daß Ablösungserscheinungen durch den Entwicklungsprozeß unterbunden werden.

Es ist davon auszugehen, daß beim erfindungsgemäßen Verfahren eine oft bei Polymerisationsvorgängen zu beobachtende Erscheinung mit zur Wirkung kommt. Ein einmal eingeleiteter Polymerisationsprozeß erfaßt durch die bei der Polymerisation freiwerdende Bindungsenergie oder andere kurzzeitige Reaktionsabläufe auch die unmittelbar benachbarten unbelichteten Harzmoleküle. Dieser Umstand erklärt, warum die eingefärbte und gar nicht oder nur schwach polymerisierte untere Harzschicht mit der oberen transparenten, hochsensibilisierten Schicht mit aushärtet. Dieser rein durch die Polymerisation bedingte Effekt wirkt natürlich auch konturenverbreiternd, aber in wesentlich kleineren räumlichen Ausdehnungsbereichen, als dies die reflektierte Strahlung verursacht. Die unter der höher sensibilisierten, transparenten Harzschicht befindliche nicht oder nur schwach photosensibilisierte, aber eingefärbte Harzschicht wird also durch die in der in der transparenten Harzschicht initiierte Photopolymerisation zur Copolymerisation angeregt.

Dieser Vorgang kann auch so verstanden werden, daß ein Sensibilisatormolekül durch Lichteinstrahlung in radikalische Bruchstücke dissoziiert, die eine Polymerisation der umliegenden Harzmoleküle bewirken, wobei sich das Radikal entweder verbraucht oder nicht verbraucht. Im zuletzt genannten Fall kann das Radikal, bevor es eine oder mehrere Polymerisationen bewirkt, in die untere, eingefärbte Harzschicht hineindiffundieren.

Die Schichten setzen sich aus dem Basisharzsystem, Fotoinitiator und einem Pigmentfarbstoff zusammen:

Das Basisharzsystem besteht aus einer der folgenden Komponenten oder aus einem Copolymerisat dieser:

Hydroxymethylacrylat
aromatisches Acrylat
Methylmethacrylat
Polyepoxid
Als Foto-Sensibilisator oder -Initiator wird verwendet:
Ein Titanocen
(z. B. Titanocendichlorid, $\mu$-Chlorbis-$\mu$-Methylentitan, Methyltristitan)
N-Vinylpyrrolidone
Ferrocen
oder Mischungen dieser Komponenten.

Bei den Farbstoffen handelt es sich um ein an sich bekanntes Farbpigment, wobei es nur darauf ankommt, daß diese Pigmente in der Harzsubstanz in sehr feiner Verteilung (ca. 1 $\mu$m Partikelgröße) mit Harzkanälen zwischen den Pigmenten vorliegen. Durch diese Anordnung wird beijeder Lichtreflexion ein Teil der Lichtenergie dissipativ absorbiert, d. h. letztlich in Wärme umgesetzt. Die dadurch bedingte Temperatursteigerung ist aber zu gering, um einen thermisch induzierten Vernetzungsvorgang einzuleiten.

Man kann diesen Vorgang auch dadurch günstig gestalten, daß man in die untere und eingefärbte Harzschicht eine geeignete Substanz einbringt, welche mit den durch die Belichtung freigesetzten Radikalen reagiert, z. B. die Radikale letztlich abfängt, um ungewünschte Verbreiterungen der Konturen zu verhindern, wenn diese Radikale nicht durch den Polymerisationsvorgang selbst verbraucht werden.

Die Vorgänge, welche im Hinblick auf die Lichtabsorption in den beiden Harzschichten ablaufen, lassen sich durch das Lambert-Beersche Gesetz beschreiben. Dieses lautet bekanntlich

$$I = I0 \cdot e^{-\varepsilon \cdot x}$$

Hierin sind $\varepsilon$ der Absorptionskoeffizient, x die durchstrahlte Dicke, I die nach der Dicke x verbleibende Strahlungsintensität und I0 die Intensität der Strahlung, die auf die Oberfläche der Lackschicht auftrifft. Da hier zwei verschieden absorbierende Schichten vorliegen, kann man diese Vorgänge wie folgt beschreiben:

Die Strahlungsabsorption in der oberen bzw. zweiten Harzschicht verläuft gemäß

$$I1 = I0 \cdot e^{-\varepsilon 1 \cdot x1}$$

und jene in der zweiten Lackschicht entsprechend

$$I2 = I1 \cdot e^{-\varepsilon 2 \cdot y}$$

Hierin sind $\varepsilon 1$ und $\varepsilon 2$ jeweils die Absorptionskoeffizienten der oberen bzw. unteren Lackschicht und x1 bzw. y die durchstrahlten Dicken.

Während $\varepsilon 1$ im wesentlichen nur die Absorption infolge der Spaltung der Sensibilisatormoleküle bzw. Harzmoleküle in Radikale beinhaltet, umfaßt der Absorptionskoeffizient $\varepsilon 2$ auch und vor allem die Absorption durch den Farbstoff. Durch geeignete Wahl des Farbstoffs kann dieser Absorptionskoeffizient so groß gewählt werden, daß die verbleibende Reststrahlungsintensität I2 wesentlich kleiner als I1 nach wenigen (etwa 5) μm Schichtdicke ist. Hierdurch wird eine Reflexion bzw. Streuung der die untere Harzschicht durchlaufenden Strahlung am Schablonenkörper verhindert und damit im Falle eines Siebs eine Polymerisation in den Öffnungen dieses Siebs. Eine Konturenverbreiterung tritt somit nicht mehr auf, was auch für den Fall nicht siebförmiger Schablonenkörper gilt.

Mit dem erfindungsgemäßen Verfahren läßt sich u. a. eine Druckschablone herstellen, deren Schablonenkörper als flaches oder zylindrisches Metallsieb vorliegt. Im fertigen Zustand der Druckschablone ist der Schablonenkörper bereichsweise durch eine transparente und photopolymerisierte bzw. ausgehärtete Harzschicht abgedeckt, wobei zwischen der Oberfläche des Schablonenkörpers und der transparenten und photopolymerisierten Harzschicht eine wenigstens eingefärbte Harzschicht liegt, die ebenfalls photopolymerisiert bzw. ausgehärtet ist. Beide Harzschichten haften fest am Schablonenkörper.

Die Erfindung wird nachfolgend unter Bezugnahme auf die Zeichnung näher beschrieben. Es zeigen:

**Figur 1** einen siebförmigen Schablonenkörper im Schnitt;

**Figur 2** eine Draufsicht auf den siebförmigen Schablonenkörper nach Figur 1;

**Figur 3** den mit einer ersten und eingefärbten Harzschicht bedeckten siebförmigen Schablonenkörper;

**Figur 4** den mit einer weiteren und transparenten Harzschicht bedeckten siebförmigen Schablonenkörper;

**Figur 5** eine Draufsicht auf eine erfindungsgemäß hergestellte Siebdruckschablone;

**Figur 6** eine entsprechende Draufsicht auf eine Siebdruckschablone nach dem Stand der Technik;

**Figur 7** einen Verfahrensschritt zur Beschichtung eines hohlzylindrischen Metallsiebs mit einer Harzschicht;

**Figur 8** einen entsprechenden Verfahrensschritt, bei dem jedoch die Harzschicht auf das Metallsieb aufgesprüht wird;

**Figur 9** einen Verfahrensschritt zum Aufbringen einer ersten Lackschicht mittels einer Doppelrakel auf ein zylindrisches Metallsieb;

**Figur 10** einen Verfahrensschritt zum Aufbringen einer zweiten Lackschicht auf die gemäß Figur 9 aufgebrachte erste Lackschicht;

**Figur 11** einen Verfahrensschritt zum Aufbringen von Lackschichten auf einen metallischen Hohlzylinder mit geschlossener Mantelfläche;

**Figur 12** einen Verfahrensschritt zum Aufbringen einer Lackschicht mittels einer Ringrakel auf einen Hohlzylinder mit geschlossener Mantelfläche;

**Figur 13** einen Längsschnitt durch einen Hohlzylinder mit geschlossener Mantelfläche, auf der zwei lichtempfindliche Lackschichten liegen;

**Figur 14** einen Längsschnitt gemäß Figur 13 nach musterbedingter Belichtung der Lackschichten;

**Figur 15** einen Längsschnitt gemäß Figur 14 nach durchgeführter Entwicklung;

**Figur 16** einen Längsschnitt gemäß Figur 15 nach Aufbringen einer Nickelschicht auf die so erhaltene Struktur;

**Figur 17** eine Belichtungsvorrichtung zur Belichtung von beschichteten Grundkörpern;

**Figur 18** eine Seitenansicht der Belichtungsvorrichtung nach Figur 17;

**Figur 19** eine weitere Belichtungsvorrichtung zur Belichtung von beschichteten Grundkörpern, die sich durch Druckluft aufblasen lassen; und

**Figur 20** einen Verfahrensschritt zur Entwicklung belichteter Harz- bzw. Lackschichten.

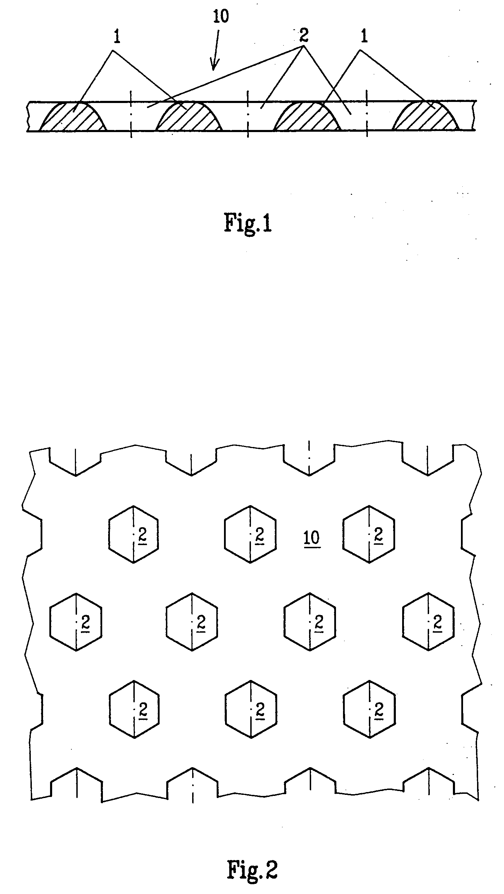

Die Figur 1 und 2 zeigen ein Nickelsieb 10 im Querschnitt und in der Draufsicht. Dabei sind die Stege des Siebes 10 mit dem Bezugszeichen 1 und die Öffnungen des Siebes 10 mit dem Bezugszeichen 2 versehen. Letztere besitzen z. B. den Querschnitt eines regelmäßigen Sechsecks.

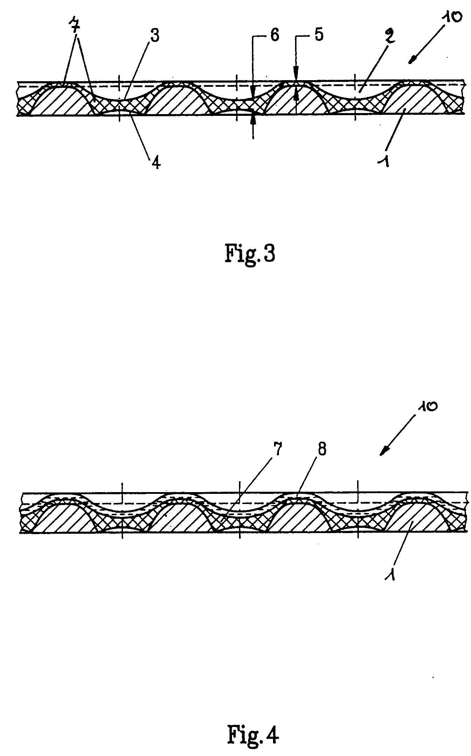

Die Figur 3 zeigt den Querschnitt des Nickelsiebs 10, wenn dieses mit der ersten bzw. eingefärbten Harzschicht 7 ausgerüstet ist. Das Harz dieser Schicht 7 wird in flüssigem und durch Lösungsmittel (z. B. Wasser) verdünntem Zustand auf das Sieb 10 aufgebracht. Unter der Wirkung der Oberflächenspannung bilden sich Menisken 3 und 4. Während der Trocknung der ersten Harzschicht 7 schrumpft das Harzvolumen, was dazu führt, daß die Schichtdicke 5 in den Öffnungen 2 und auch die Schichtdicke 6 im Bereich eines Stegs 1 kleiner wird.

Die Figur 4 zeigt einen Querschnitt durch das zweifach beschichtete Nickelsieb 10. Auf der ersten Harzschicht 7, die mit lichtabsorbierendem Farbstoff eingefärbt ist und einen Photosensibilisator in geringer Menge enthält, kommt eine zweite Harzschicht 8 zu liegen. Diese zweite Harzschicht 8 ist transparent und enthält einen Photosensibilisator in einer größeren Menge. Licht, welches diese obere bzw. zweite Harzschicht 8 durchsetzt, bewirkt entsprechend dem Lambert-Beerschen Gesetz eine Photopolymerisation der in dieser Schicht enthaltenen Harzmoleküle. Der verbleibende Lichtstrom wird von den Stegen 1 mit metallischer Oberfläche in die Öffnungen 2 gestreut und anschließend sehr bald von den Farbstoffmolekülen in der ersten Harzschicht 7 abgefangen und ohne Einleitung von Polymerisation dissipiert, so daß nur in der engsten Umgebung der Stege 1 Polymerisationsvorgänge ausgelöst werden können.

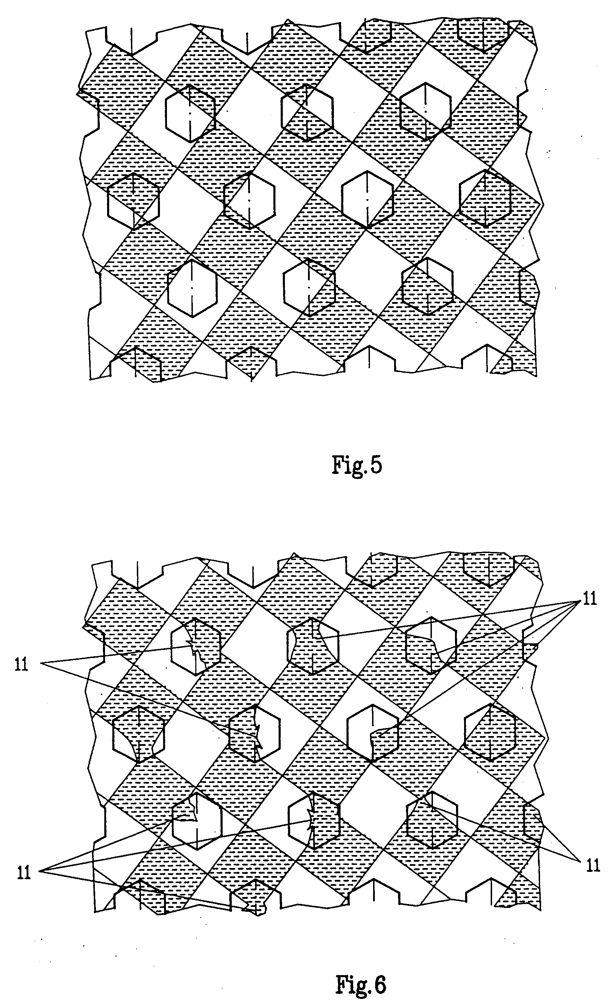

Die Figur 5 zeigt ein Ergebnis, wie es nach dem erfindungsgemäßen Verfahren erhalten wird, also nach Doppelbeschichtung des Siebs sowie nach Belichtung und Entwicklung. Das Sieb 10 ist hier mit einem schachbrettartigen Muster belichtet worden und die Konturen sind äußerst scharf.

Demgegenüber zeigt die Figur 6 das Ergebnis nach einem völlig gleichartig durchgeführten Belichtungs- und Entwicklungsprozeß bei einer einfachen, normal sensibilisierten Harzschicht. Man erkennt jene Bereiche 11, in welchen unerwünschte sekundäre Polymerisation aufgrund des von den Rändern der Öffnungen 2 reflektierten Lichts stattgefunden hat.

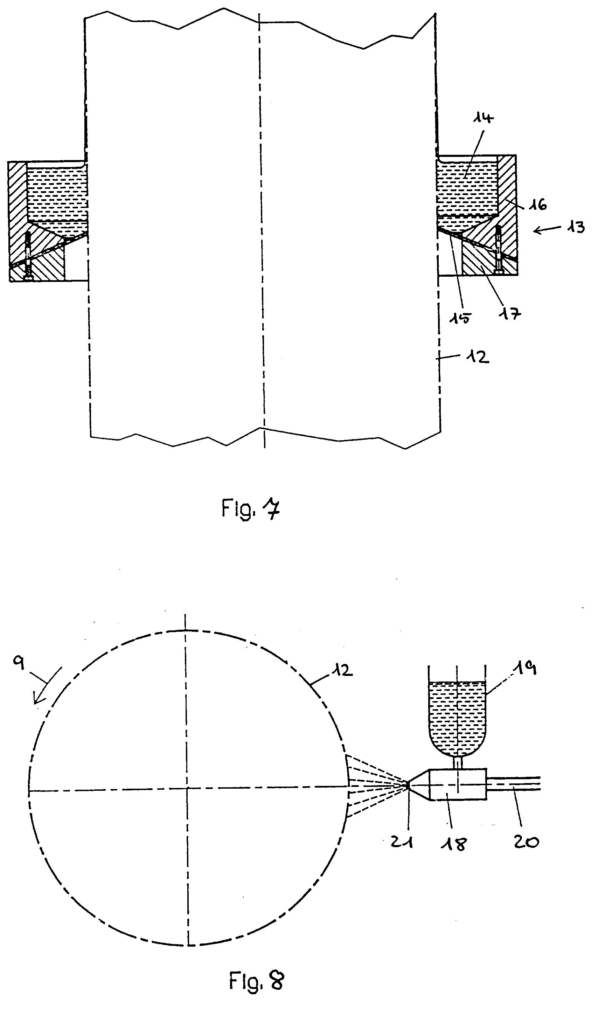

Die Figur 7 zeigt ein metallisches Rundsieb 12, welches unter Verwendung einer Ringrakel 13 nacheinander mit der ersten Harzschicht 7 und dann mit der zweiten Harzschicht 8 beschichtet wird. Das jeweils flüssige Harz bzw. Photopolymer befindet sich in einer kreisringförmigen Wanne 14 und kann dank einer dichtend an dem Rundsieb 12 anliegenden Gummilippe 15 nicht aus der Wanne 14 herausfließen. Die Gummilippe 15 wird zwischen einem Ringrakeloberteil 16 und einem Ringrakelunterteil 17 gehalten. Das Photopolymer weist etwa eine Viskosität eines zähen Motoröls auf und kann zufolge einer nach abwärts gerichteten Bewegung der Ringrakel 13 nicht durch das Rundsieb 12 in dessen Innenraum fließen. Der Grund liegt darin, daß der statische Druck, unter dem das zähflüssige Photopolymer steht, nur dem Stand der Flüssigkeitshöhe in der Wanne 14 der Ringrakel 13 entspricht und daher sehr gering ist. Auch kommt dieser statische Druck auf einen Längenabschnitt des Rundsiebs 12 nur ganz kurze Zeit zur Wirkung, und zwar so lange, wie die Ringrakel 13 aufgrund ihrer nach abwärts gerichteten Geschwindigkeit benötigt, um die Höhe des Flüssigkeitsstands in der Wanne 14 zu durchlaufen.

Das Rundsieb 12 ist so engmaschig, daß der geringe statische Druck zwar ausreicht, das Photopolymer innerhalb der verfügbaren Zeit in die Bohrungen zu drücken und diese aufzufüllen, nicht aber reicht dieser Druck aus, um die sich gegen das Innere des Rundsiebs 12 in jeder kleinen kapillaren Bohrung ausbildende Flüssigkeitsmembran zu überdrücken und so aufzureißen. Dadurch ist ein Austritt von Photopolymer in das Innere des Rundsiebs 12 auch bei Verringerung der Absenkgeschwindigkeit der Ringrakel 13 weitgehend unmöglich. Um die beiden oben genannten Harzschichten 7 und 8 nacheinander aufbringen zu können, werden vorzugsweise unterschiedliche Ringrakeln 13 verwendet.

Alternativ kann aber auch eine Beschichtung des Rundsiebs 12, wenn es gemäß Figur 8 in Richtung des Pfeils 9 gedreht wird, mittels einer Zerstäuberdüse 18 erfolgen. Dabei wird die Zerstäuberdüse 18 in Richtung der Längsachse des Rundsiebs 12 bewegt. Das Photopolymer, welches sich in einem Becher 19 oberhalb der Zerstäuberdüse 18 befindet, wird durch eine injektorartige Vorrichtung im Inneren der Zerstäuberdüse 18 aus dem Becher 19 angesaugt und mit der den Injektor betreibenden Druckluft, die durch einen Schlauch 20 zugeführt wird, durch ein Mundstück 21 der Zerstäuberdüse 18 ausgestoßen und dort nach an sich bekannter Weise zerstäubt. Dies wird z. B. durch einen unter mehr als 2 bar Überdruck stehenden Luftstrahl erreicht, in welchem intensive Ultraschallwellen auftreten, durch die das Photopolymer in kleinste Flüssigkeitsteilchen zerrissen wird. Dank der Drehbewegung des Rundsiebs 12 und der gleichzeitig erfolgenden Vorschubbewegung der Zerstäuberdüse 18 in axialer Richtung des Rundsiebs 12 wird der Photopolymernebel gleichmäßig auf der Oberfläche des Rundsiebs 12 verteilt. Zum Aufbringen der unterschiedlichen Harzschichten 7 und 8 können unterschiedliche Zerstäuberdüsen 18 bzw. Becher 19 verwendet werden.

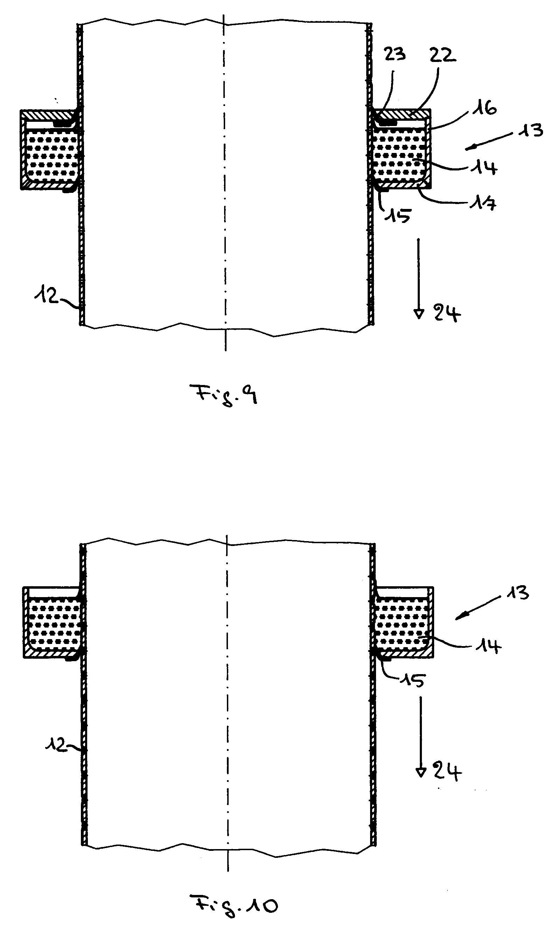

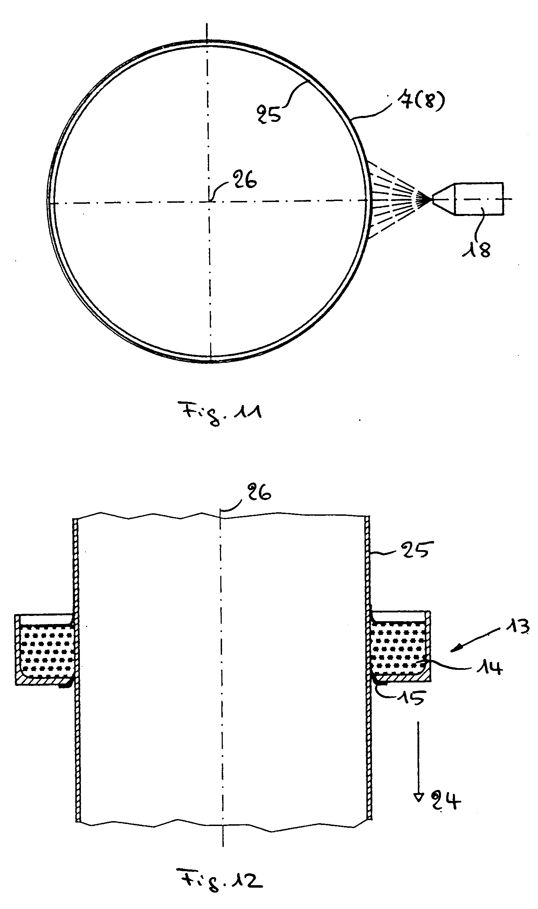

Die Figuren 9 und 10 zeigen das Aufbringen von Lackschichten auf das metallische Zylindersieb 12 nach einer anderen Variante. Die Ringrakel 13 trägt hier zusätzlich einen Deckel 22 mit einer ebenfalls ringförmigen Gummilippe 23 bzw. Abstreifrakel. Dabei wird die Ringrakel 13 in Richtung des Pfeils 24 entlang der Achse des Zylindersiebs 12 bewegt. Durch die zweite Gummilippe 23 wird erreicht, daß bei der ersten Beschichtung des Zylindersiebs 12 das Harz die Sieböffnungen vollständiger ausfüllt, weil die zweite Gummilippe 23 große Teile des auf den Stegen befindlichen Harzes in das Innere der Öffnungen 2 streicht. Dabei kann die zweite Gummilippe 23 vom Material her weicher sein als die erste Gummilippe 15, um ein Verkratzen der bereits aufgetragenen Harzschichtbereiche durch die zweite Gummilippe 23 zu verhindern.

Die Figur 10 zeigt den Schritt, bei dem auf die bereits erste Harzschicht eine zweite Harzschicht mit der Ringrakel 13 aufgetragen wird, wobei sich jetzt in der Wanne 14 das im wesentlichen transparente Harzmaterial befindet. Beim Aufbringen der zweiten Harzschicht wird nur noch mit der Gummilippe 15 gearbeitet, während die Gummilippe 23 nach Figur 9 nicht mehr verwendet zu werden braucht.

Im Falle der Figur 11 werden die erste und die zweite Harzschicht durch die Zerstäuberdüse 18 auf einen hohlzylindrischen Grundkörper 25 aufgebracht, der hier ein metallischer Hohlzylinder mit geschlossener Mantelfläche ist. Beim Aufbringen der Harzschichten dreht er sich um seine Zylinderachse 26, während die Zerstäuberdüse 18 parallel zur Zylinderachse 26 bewegt wird.

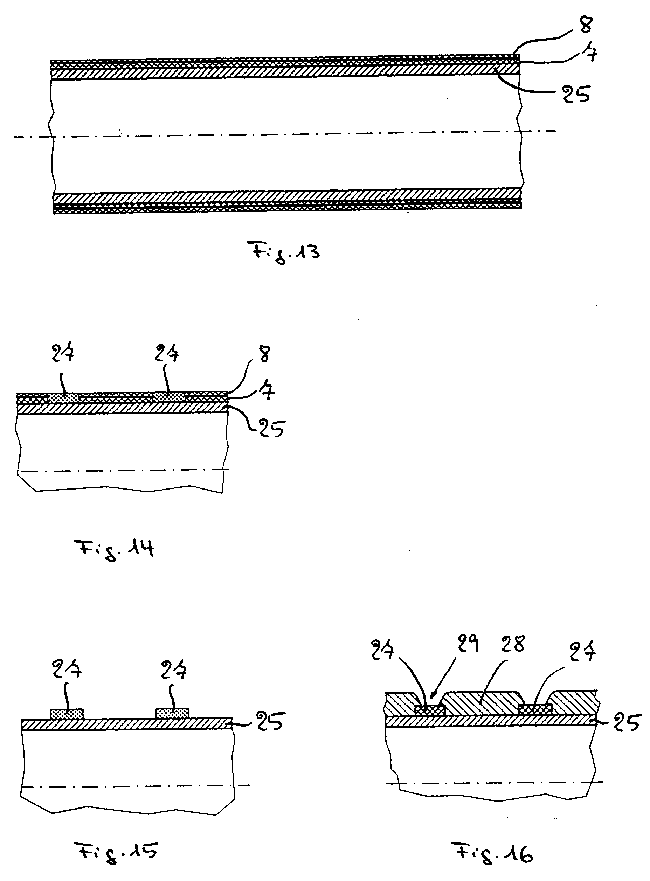

Alternativ dazu kann der metallische Hohlzylinder mit geschlossener Mantelfläche gemäß Figur 12 auch mit der bereits erwähnten Ringrakel 13 mit den beiden genannten Lackschichten versehen werden. Hier wird wiederum die Ringrakel 13 in Richtung des Pfeils 24 entlang der Zylinderachse 26 bewegt, wobei nur die untere Gummilippe 15 verwendet zu werden braucht, da der Hohlzylinder umfangsseitig keine Öffnungen aufweist.

Die Figur 13 zeigt das Ergebnis dieses Beschichtungsvorgangs in größerordnungsmäßig verzerrter Darstellung. Der metallische Hohlzylinder 25 mit geschlossener Mantelfläche ist hier mit der ersten Lackschicht bzw. Harzschicht 7 und mit der zweiten Lackschicht bzw. Harzschicht 8 abgedeckt. Die Dicken dieser Lackschichten sind gegenüber dem Durchmesser erheblich größer dargestellt.

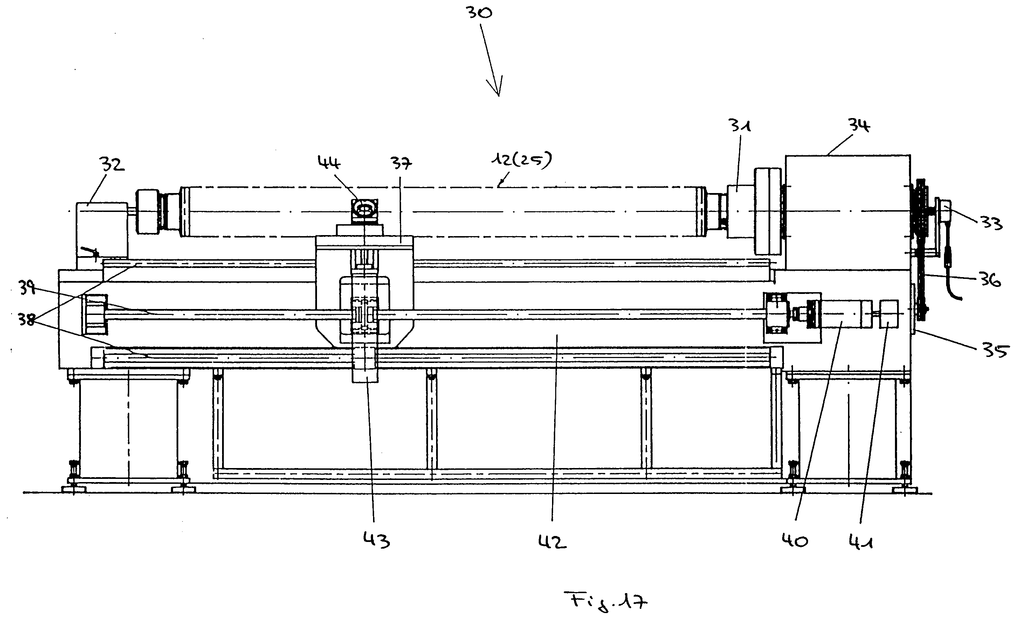

Die Figur 14 zeigt einen Ausschnitt aus dem beschichteten Hohlzylinder gemäß Figur 13, nachdem die Lackschichten 7, 8 gemäß einem vorbestimmten Muster belichtet worden sind. Sie sind lichtempfindlich im Sinne einer Polymerisationsfähigkeit durch Licht, wie bereits erwähnt. Bereiche 27 der Lackschichten 4a, 4b wurden belichtet und erfuhren hierdurch eine strukturelle Veränderung. In diesen Bereichen 27 wurden vorhandene Doppelbindungen aufgebrochen und diese reagieren mit benachbarten Kettenmolekülen des Lackes bzw. des Harzes, weil in diesen gleichartig aufgebrochene Doppelbindung bestanden haben. Es kommt zu einer Quervernetzung (crosslinking) und damit zu einer Härtung. Durch diese Vernetzung wird eine höhere chemische Beständigkeit erreicht, was für den anschließenden Entwicklungsvorgang notwendig ist.

Die Figur 15 zeigt die Struktur nach Figur 14 nach durchgeführter Entwicklung. Im Ergebnis verbleiben nach dem Entwicklungsvorgang die vernetzten Bereiche 27 auf der Oberfläche des Hohlzylinders 25.

In einem weiteren und nicht dargestellten Verfahrensschritt erfolgt anschließend eine thermische Nachhärtung der auf dem Hohlzylinder 25 verbliebenen Bereiche 27 der Harzschichten 7, 8. Durch Einbrennen oder Tempern bei Temperaturen von etwa 140 bis 160 °C werden alle noch in den auf dem Hohlzylinder 25 verbliebenen Harzbereichen 27 vorhandenen Doppelbindung quervernetzt und damit ein besonders gutes Verhalten im nächsten Prozeßschritt bzw. Entwicklungsschritt bewirkt.

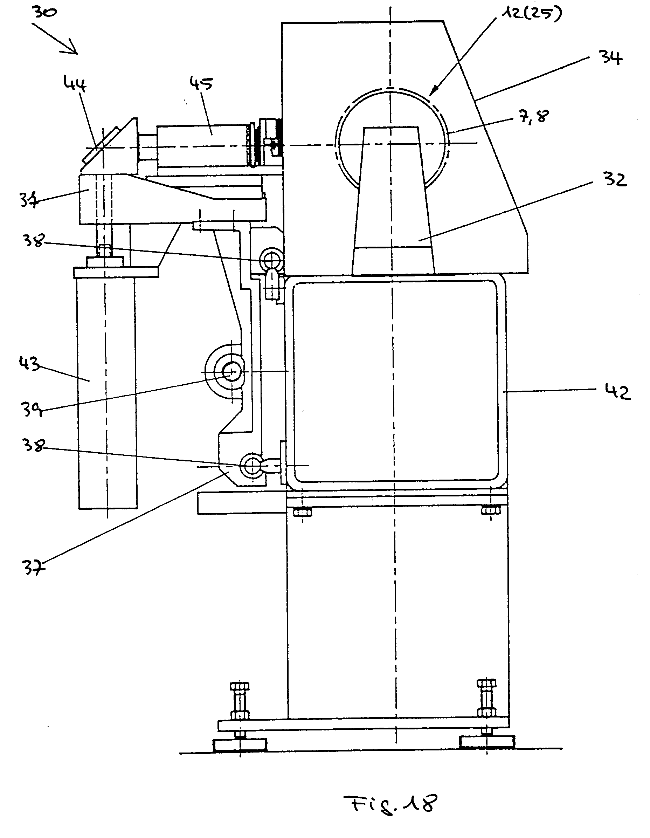

Dieser Schritt ist in Figur 16 gezeigt. Es handelt sich hierbei z. B. um einen Aufnickelungsvorgang in einem galvanischen und manchmal auch chemischen Nickelbad. Nickel wird jetzt auf die metallisch blanken Stellen des Hohlzylinders 25 zwischen den vernetzten Bereichen 27 abgelagert. Auf diese Weise bilden sich Nickelstege 28, die zusammenhängen und ein Zylindersieb ergeben, das dann in geeigneter Weise vom Hohlzylinder 25 abgenommen werden kann. Zu diesem Zweck lassen sich z. B. von außen geeignete Schubspannungen in das Nickelsieb einbringen, indem es gemeinsam mit dem Hohlzylinder 25 lediglich eingedellt wird.

Durch das Einbrennen oder Nachtempern sind die Bereiche 27 sehr chemikalienfest geworden und dadurch auch weniger anfällig für ein Aufquellen in der Badflüssigkeit. Insbesondere bei einem galvanischen Aufnickelungsvorgang kann es bei nicht ausreichend chemikalienfesten Schichten zu einem Quellen kommen und in weiterer Folge zu einem Durchschlag des Stroms durch die Schichten hindurch. Es würden sich dann auf diesen Schichten Nickelperlen bilden, die sich schließlich mit den Stegen 28 verbinden und die Sieböffnungen 29 verschließen würden.

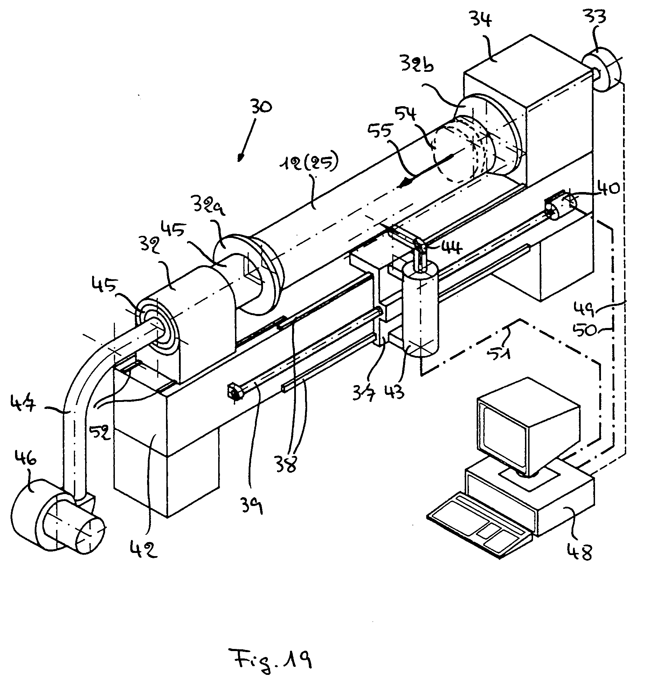

Anhand der Figur 17 und 18 wird der nachfolgende Verfahrensschritt der Belichtung mit Hilfe eines Lasers beschrieben. Durch diesen Laser werden die zu vernetzenden Harzschichten punktweise an den musterbedingt zu vernetzenden Stellen belichtet und damit verfestigt. Diese Stellen bleiben später nach der Entwicklung der Harzschichten stehen.

Der Grundkörper, darunter versteht man das mit den Harzschichten 7 und 8 beschichtete Rundsieb 12 oder den Hohlzylinder 25 bzw. Vollzylinder, wird in eine Rotationsbelichtungsmaschine 30 zwischen ein Spannfutter 31 und einen Reitstock 32 eingelegt. Durch das Schließen des Spannfutters 31 wird mit dem Grundkörper 12 bzw. 25 ein Drehlagendecoder 33 drehsteif verbunden. Letzterer ist auf der rechten Seite eines Spindelstocks 34 der Rotationsbelichtungsmaschine 30 angeordnet. Der rotatorische Antrieb des Grundkörpers 12, 25 und der mit diesem verbundenen Anlagenteile erfolgt durch einen Hauptantriebsmotor 35 über einen schwingungsgedämpften Keilriementrieb 36. Während sich der Grundkörper 12, 25 dreht, wird ein Optikschlitten 37 entlang von Führungen 38 mit Hilfe einer Vorschubspindel 39 und einem mit dieser gekuppelten Schrittmotor 40 bewegt. Am rechten Wellenende des Schrittmotors 40 wird ein Drehschwingungsdämpfer 41 aufgesetzt. Die Führungen 38 und die Vorschubspindel 39 sind an einem Führungsbett 42 der Rotationsbelichtungsmaschine 30 gelagert.

In den Figur 17 und 18 ist ein mit dem Optikschlitten 37 verbundener und mitgeführter Laser 43 vorhanden, dessen Laserstrahl über einen Umlenkspiegel 44 aus der ursprünglich vertikalen Richtung in eine horizontale Richtung umgelenkt wird, so daß er dann über eine Optik 45 radial auf die Oberfläche des Grundkörpers 12, 25 fokussiert wird.

Zur Stabilisierung der Schablonenwandung in radialer und tangentialer Richtung können Führungselemente (Rollen, Gleitführungen) vorgesehen werden, jedoch ist dies natürlich nur bei solchen Photopolymeren möglich, welche schon im nichtvernetzten Zustand eine trockene, d. h. feste Oberfläche aufweisen.

Statt des mitgeführten Lasers 43 kann auch ein ortsfester Laser zum Einsatz kommen, dessen Laserstrahl über eine geeignete Umlenkoptik radial auf die Oberfläche des Grundkörpers 12, 25 gerichtet wird.

Zum Zwecke der punktweisen Belichtung der Oberfläche des Grundkörpers 12, 25 kann die Laserstrahlung z. B. über einen akusto-optischen Modulator ein- oder ausgeschaltet werden, so daß die Beaufschlagung der Rundform mit Laserstrahlung pulsförmig erfolgt.

Die Figur 19 zeigt eine alternative Bearbeitung des Grundkörpers in einer Rotationsbelichtungsmaschine. Gleiche Elemente wie in den Figuren 17 und 18 sind dabei mit den gleichen Bezugszeichen versehen.

Bei einem Grundkörper handelt es sich wiederum entweder um das mit den Lackschichten 7 und 8 beschichtete metallische Zylindersieb 12 oder um den mit den Lackschichten 7, 8 beschichteten Hohlzylinder 25 mit geschlossener Mantelfläche.

Der Grundkörper 12 bzw. 25 ist an seinen beiden offenen Enden abgestützt und greift an seinem reitstockseitigen Ende in einen Stützkegel 32a ein und an seinem spindelstockseitigen Ende in einen Stützkegel 32b. Der Stützkegel 32b wird über den bereits erwähnten Antrieb im Spindelstock 34 angetrieben und schließ das mit ihm verbundene Ende des Grundkörpers 12, 25 im wesentlichen dichtend ab. Über eine Hohlwelle 45 im Reitstock 32 wird Luft ins Innere des Grundkörpers 12, 25 eingeleitet, deren Druck in geeigneter Weise gegenüber dem Umgebungsdruck etwas erhöht wurde. Für die Aufbringung dieser Luft ist z. B. ein Radialgebläse 46 vorgesehen, welches über eine Luftleitung 47 die komprimierte Luft zur Hohlwelle 45 führt. Durch die komprimierte Luft wird der Grundkörper so weit aufgeblasen, daß er einen kreisrunden Querschnitt erhält. In Abwandlung vom gezeigten Ausführungsbeispiel könnte Luft auch durch beide Stirnseiten in den Grundkörper eingeblasen werden. Hierzu müßte die Vorrichtung an der Seite des Spindelstocks entsprechend umgestaltet werden.

Der Optikschlitten 37 wird bei aufgeblasenem Grundkörper und bei Drehung des Grundkörpers um seine Längsachse in Längsrichtung des Grundkörpers 12, 25 entlang der Führungen 38 mittels der Vorschubspindel 39 und dem Schrittmotor 40 verschoben. Dabei wird der auf dem Optikschlitten 37 sitzende Festkörperlaser 43 entsprechend mitbewegt. Dieser Festkörperlaser 43 wird im Takt der Musterinformation ein- bzw. ausgeschaltet. Der Drehwinkelgeber 33 gibt die jeweilige Winkellage des Grundkörpers 12, 25 an einen Rechner 48 über eine Datenleitung 49. Der Rechner 48 übermittelt über eine nicht mehr gezeigte Steuereinheit die Schrittimpulse an den Schrittmotor 40 über eine Leitung 50 und die Ein- und Ausschaltbefehle an den Festkörperlaser 43 über eine Leitung 51.

Der Reitstock 32 kann in Längsrichtung des Grundkörpers 12, 25 verschoben werden und ist hierzu auf Führungen 52 angeordnet, die sich auf dem Maschinenbett 42 befinden. Auf diese Weise kann die Lage des Reitstocks 32 unterschiedlichen Längen des Grundkörpers 12, 25 angepaßt werden und außerdem kann der Reitstock zum Auswechseln des Grundkörpers 12, 25 von diesem abgerückt werden, so daß der Grundkörper 12, 25 auf einfache Weise nach rückwärts aus der Gravurvorrichtung 30 entnommen werden kann, also in einer Richtung, die vom Laser 43 wegweist.

Wird der Grundkörper 12, 25 von einer Seite aufgeblasen, also z. B. von der Seite des Reitstocks 32 her, so kann in ihm ein Dichtkolben 54 angeordnet werden, der vom Luftstrom in Richtung zum Spindelstock 34 verschoben wird. Dabei ist der Dichtkolben 54 mittig mit einem strangförmigen Element 55 verbunden, dessen anderes Ende in geeigneter Weise am Spindelstock 32 befestigt ist. Der Dichtkolben 54 erreicht dabei nicht ganz den Stützkegel 32b.

Durch diesen Dichtkolben ist es möglich, einerseits den Stützkegel 32b vom Innendruck im Grundkörper freizuhalten und andererseits die auf den Reitstock wirkende Druckkraft, die infolge des Aufblasens des Grundkörpers entsteht, zu kompensieren. Während also in Figur 19 die Druckkraft den Reitstock 32 nach links zu drücken sucht, wird dieser gleichzeitig infolge der Wirkung des Dichtkolbens 54 und des zwischen Dichtkolben 54 und Reitstock 32 vorhandenen strangförmigen Elements 55 nach rechts gezogen. Insgesamt wird somit ein Auseinanderdrücken von Spindelstock 34 und Reitstock 32 verhindert und damit eine Aufwölbung des Maschinenbetts 42 im Bereich zwischen Reit- und Spindelstock. Somit kann sich auch der Optikschlitten 37 nicht mehr senkrecht zur Längsachse des Grundkörpers verschieben, was zu genaueren Gravurbildern führt.

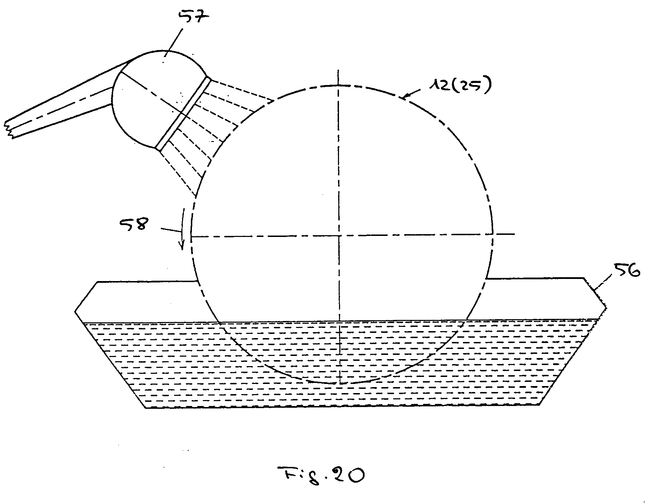

Der Verfahrensschritt zur Entwicklung des vernetzten und aus den Schichten 7 und 8 bestehenden Systems ist schematisch in Figur 20 dargestellt. Der Grundkörper 12, 25 wird in ein Entwicklermedium getaucht, welches sich in einer Wanne 56 befindet und es werden dadurch die nicht durch die Lichteinwirkung vernetzten Stellen der Schichten 7 und 8 herausgelöst. Zweckmäßigerweise kann die Entwicklerflüssigkeit aus einer alkalischen Lösung (Soda, Kalilauge, Natronlauge) bestehen. Zur Unterstützung des Entwicklungsvorgangs kann unverbrauchte Entwicklerlösung aus einer Brause 57 auf die Oberfläche des Grundkörpers 12, 25 aufgesprüht werden. Er läuft während des Entwicklungsvorgangs im Sinne der Pfeilrichtung 58 um.

Handelt es sich bei dem Grundkörper um den metallischen Hohlzylinder mit geschlossener Mantelfläche oder um einen metallischen Vollzylinder, so liegt nach der Entwicklung der lichtempfindlichen Schichten auf der Oberfläche des Zylinders ein Musterbild in Form kleiner Lackpunkte vor. Der Lack ist wasser- und einigermaßen chemikalienbeständig, so daß dieser Lack den nachfolgenden Verfahrensschritt übersteht, bei welchem in einem mäßig sauren Ni-Chlorid bzw. Ni-Sulfat-Elektrolyt Reinnickel auf der Oberfläche galvanisch aufgebracht wird. Die Lackabdeckpunkte dürfen sich hierbei nicht von der Oberfläche des Grundkörpers ablösen. Der pH-Wert des Elektrolyten liegt hierbei im Bereich pH = 3 bis 4, die Temperatur zwischen 40 und 60 °C. Der Lack muß natürlich auch bei Einwirkung des Elektrolyten isolierend bleiben.

Hohlzylinder der genannten Art können eine Länge von 2 bis 4m aufweisen und Durchmesser von 200 bis 350 mm. Bei Hohlzylindern mit geschlossener Mantelfläche beträgt die Wandstärke etwa 0,1 bis 0,3 mm. Im Innern des Hohlzylinders kann ein Kunststoff- bder Gummischlauch vorgesehen sein, der sich an das Innere des metallischen Hohlzylinders anlegt und diesen abstützt. Die Wandstärke dieses zusätzlichen Schlauchs kann 3 bis 4 mm betragen und er kann zusätzlich mit Druckluft gefüllt werden. Dadurch wird der metallische Hohlzylinder nicht nur weitgehend ausgerundet sondern bleibt auch trotz der Beanspruchung durch die Auftriebskräfte im elektrolytischen Bad weitgehend formstabil.

Nachdem die Nickelschicht aufgebracht worden ist, wird der Hohlzylinder bzw. Vollzylinder aus dem Nickelbad herausgenomen und es wird jetzt das vorhandene Nickelsieb vom Hohl- bzw. Vollzylinder abgenommen. Zur Erleichterung dieses Vorgangs können örtliche Schubspannungen in das Nickelsieb eingebracht werden. Bei hohlzylindrischem Grundkörper kann dies dadurch erfolgen, daß mit einem stumpfen, abgerundeten Gegenstand das Nickelsieb und der unter ihm liegende Hohlzylinder eingedellt werden, wobei sich der Hohlzylinder dreht.

**Patentansprüche**

1. Verfahren zur Herstellung einer Druckschablone, bei dem wenigstens folgende Schritte ausgeführt werden:

   - Bereitstellung eines Grundkörpers (12, 25);
   - Aufbringen einer wenigstens eingefärbten ersten Harzschicht (7) auf die Oberfläche des Grundkörpers (12, 25);
   - Aufbringen einer zweiten transparenten und photosensibilisierten Harzschicht (8) auf die erste Harzschicht (7);

   - ortsselektives Belichten der Harzschichten (7, 8) zwecks Vernetzung der belichteten Stellen; und
   - Entwickeln der belichteten Harzschichten (7, 8).

2. Verfahren nach Anspruch 1, **dadurch gekennzeichnet**, daß die erste Harzschicht (7) photosensibilisiert ist, jedoch schwächer als die zweite Harzschicht (8).

3. Verfahren nach Anspruch 1, **dadurch gekennzeichnet**, daß die erste Harzschicht (7) eine Substanz enthält, durch die bei Belichtung freigesetzte Radikale abgefangen werden.

4. Verfahren nach einem der Ansprüche 1 bis 3, **dadurch gekennzeichnet**, daß die Harzschichten (7, 8) jeweils mit einer Dicke von etwa 5 μm bis 10 μm aufgetragen werden.

5. Verfahren nach einem der Ansprüche 1 bis 4, **dadurch gekennzeichnet**, daß die Harzschichten (7, 8) mittels eines Laserstrahls belichtet werden.

6. Verfahren nach einem der Ansprüche 1 bis 5, **dadurch gekennzeichnet**, daß die Belichtung bei einer Wellenlänge im Bereich von 380 nm bis 532 nm erfolgt.

7. Verfahren nach einem der Ansprüche 1 bis 6, **dadurch gekennzeichnet**, daß als Grundkörper ein zylindrisches Sieb (12) verwendet wird.

8. Verfahren nach einem der Ansprüche 1 bis 6, **dadurch gekennzeichnet**, daß als Grundkörper ein flaches Sieb verwendet wird.

9. Verfahren nach einem der Ansprüche 1 bis 6, **dadurch gekennzeichnet,** daß als Grundkörper ein Hohlzylinder (25) mit geschlossener Mantelfläche verwendet wird.

10. Verfahren nach einem der Ansprüche 1 bis 6, **dadurch gekennzeichnet,** daß als Grundkörper ein Vollzylinder verwendet wird.

11. Verfahren nach einem der Ansprüche 7 bis 10, **dadurch gekennzeichnet,** daß ein aus Metall bestehender Grundkörper (12, 25) verwendet wird.

12. Verfahren nach Anspruch 9, 10 oder 11, **dadurch gekennzeichnet,** daß nach dem Entwickeln der belichteten Harzsichten (7, 8) eine metallische Schicht (28) auf den Grundkörper (25) aufgebracht und anschließend vom Grundkörper (25) abgenommen wird.

**13.** Verfahren nach Anspruch 11 und 12, **dadurch gekennzeichnet,** daß die metallische Schicht (28) galvanisch aufgebracht wird.

**14.** Verfahren nach Anspruch 7 oder 9, **dadurch gekennzeichnet,** daß der Hohlzylinder (12, 25) über wenigstens eine seiner Stirnseiten mittels eines Druckgases so weit aufgeblasen wird, daß er einen kreisrunden Querschnitt erhält.

**15.** Verfahren nach Anspruch 14, **dadurch gekennzeichnet,** daß als Druckgas Luft verwendet wird.

Fig.1

Fig.2

Fig.3

Fig.4

Fig.5

Fig.6

Fig. 7

Fig. 8

Fig. 9

Fig. 10

Fig. 11

Fig. 12

Fig. 13

Fig. 14

Fig. 15

Fig. 16

Fig. 14

Fig. 18

Fig. 19

Fig. 20

Europäisches
Patentamt

## EUROPÄISCHER RECHERCHENBERICHT

Nummer der Anmeldung

EP 95 10 2102

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | DE-A-16 22 302 (TELEFUNKEN PATENTVERWERTUNGDGESELLSCHAFT) | 1 | G03F7/12 B41C1/14 |
| Y | * Seite 2, Zeile 18 - Seite 3, Zeile 16; Ansprüche 1,3 * <br> --- | 1-15 | G03F7/095 |
| Y,D | EP-A-0 593 806 (SCHABLONENTECHNIK KUFSTEIN) <br> * das ganze Dokument * <br> --- | 1-15 | |
| X | US-A-4 266 007 (N.E. HUGHES) <br> * Ansprüche 4,5 * <br> --- | 2 | |
| X | GB-A-2 049 972 (ASAHI KASEI KOGYO K.K.) <br> * Ansprüche 8,9 * <br> --- | 2,3 | |
| Y | FR-A-2 169 033 (BUCKHEE-MEARS CO.) <br> * das ganze Dokument * <br> --- | 1 | |
| Y | FR-A-2 375 624 (HOECHST A.G.) <br> * Seite 3, Zeile 5 - Zeile 6; Ansprüche; Abbildung 7 * <br> --- | 1 | RECHERCHIERTE SACHGEBIETE (Int.Cl.6) |
| A | EP-A-0 182 195 (FERD. RÜESCH AG.,) <br> * Anspruch 5 * <br> --- | | G03F B41C |
| A | DE-A-36 01 327 (SCHABLONENTECNIK KUFSTEIN GMBH,.) <br> * das ganze Dokument * <br> --- | 1 | |
| A | DE-A-42 43 750 (SCHEPERS H.G.) <br> * das ganze Dokument * <br> ----- | 1 | |

Der vorliegende Recherchenbericht wurde für alle Patentansprüche erstellt

| Recherchenort | Abschlußdatum der Recherche | Prüfer |
|---|---|---|
| DEN HAAG | 2.August 1995 | Rasschaert, A |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)